# EUROPEAN PATENT SPECIFICATION

(11) **EP 1 313 218 B1**
(45) Date of publication and mention of the grant of the patent: **16.03.2011**
(21) Application number: 01956904.5
(22) Date of filing: 15.08.2001
(51) Int. Cl.: H03H 9/05, H03H 9/64, H03H 9/10

(54) **SURFACE ACOUSTIC WAVE FILTER DEVICE**
AKUSTISCHE OBERFLÄCHENWELLENANORDNUNG
DISPOSITIF DE FILTRATION D'ONDES ACOUSTIQUES DE SURFACE

(30) Priority: 21.08.2000 JP 2000249954; 26.07.2001 JP 2001225768
(43) Date of publication of application: 21.05.2003
(60) Divisional application: 10173569.4
(73) Proprietor: MURATA MANUFACTURING CO., LTD., Nagaokakyo-shi, Kyoto 617-8555 (JP)
(72) Inventor: TANIGUCHI, N, c/o Murata Manufacturing Co., Ltd., Nagaokakyo-shi, Kyoto 617-8555 (JP); TAKATA, T. c/o Murata Manufacturing Co., Ltd., Nagaokakyo-shi, Kyoto 617-8555 (JP); TAKEDA, Mitsuo, c/o Murata Manufacturing Co., Ltd., Nagaokakyo-shi, Kyoto 617-8555 (JP)
(74) Representative: Schoppe, Fritz
(86) International application number: PCT/JP2001/007042
(87) International publication number: WO 2002/017483

(56) References cited:
- EP-A- 0 853 381
- EP-A1- 0 541 284
- EP-A2- 0 897 218
- JP-A- 5 183 380
- JP-A- 10 070 435
- JP-A- 10 093 382
- JP-A- 63 263 809
- JP-A- 2000 223 989
- JP-A- 2000 223 989
- JP-A- 2001 160 731
- US-A- 5 471 722

## Description

### Technical Field

The present invention relates to a surface acoustic wave filter, and particularly to a surface acoustic wave filter device having a ladder type circuit.

### Background Art

There has been known a band-pass filter having a ladder type circuit wherein a plurality of one terminal pair surface acoustic wave resonators are connected in ladder shape (e.g., Japanese Unexamined Patent Application Publication No. 05-183380).

In this band-pass filter, a plurality of one terminal pair surface acoustic wave resonators are connected in series between input terminal and output terminal as series arm resonators, and define series arms. In addition, a plurality of one terminal pair surface acoustic wave resonators are connected in parallel between the series arms and ground as parallel arm resonators, and define parallel arms.

The band-pass filter having the ladder type circuit has small insertion loss and wide pass band, and is widely used as a band-pass filter in a portable telephone

The Japanese Unexamined Patent Application Publication No. 05-183380 discloses that an inductance component is connected in series to the above-described series arm resonator or parallel arm resonator, and this allows the band-widening of filter characteristics.

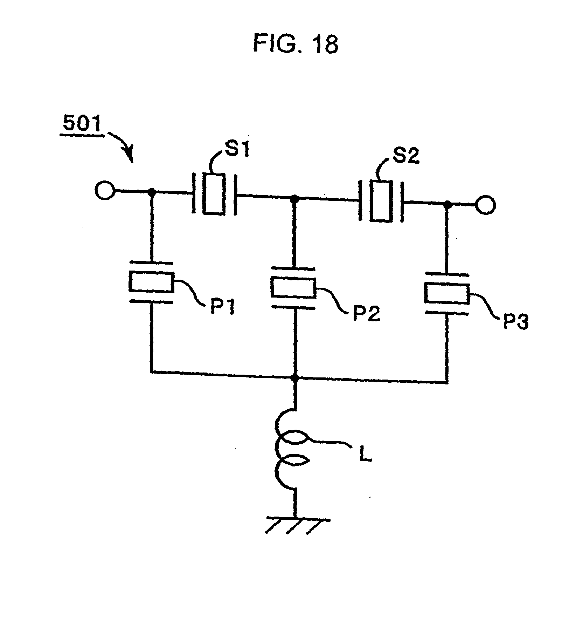

Also, the Japanese Unexamined Patent Application Publication No. 10-93382 discloses a structure wherein an inductance is added to parallel arm resonators in a surface acoustic wave filter device having a ladder type circuit. Fig. 18 shows a circuit configuration of the surface acoustic wave filter device disclosed in this prior art. In the surface acoustic wave filter device 501, series arm resonators S1 and S2 and parallel arm resonators P1 to P3 are connected to one another so as to constitute a ladder type circuit. Here, an inductance L is inserted between the parallel arm resonators P1 to P3 and the ground potential, and thereby the widening of pass band and the increase in attenuation value in the vicinity of a pass band are achieved.

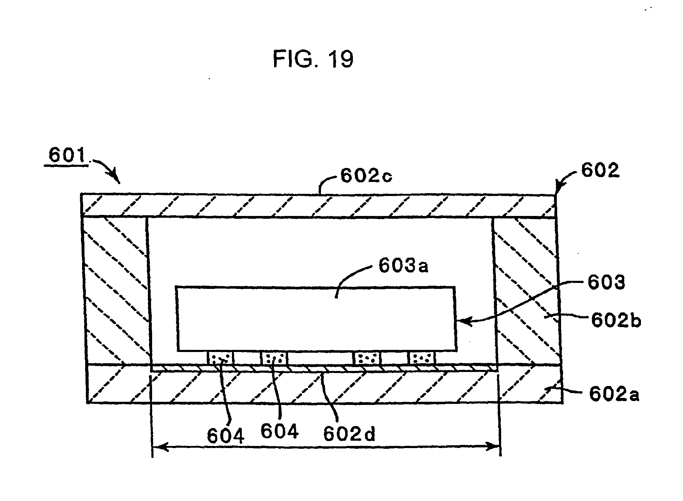

On the other hand, Japanese Unexamined Patent Application Publication No. 04-65909 discloses a structure in which a surface acoustic wave filter element is connected to a package by means of the face down process. Conventionally, in the package in which the surface acoustic wave filter element is accommodated, the electrodes of a package and those of the surface acoustic wave filter element has been connected by bonding wires. In contrast, the surface acoustic wave filter device disclosed in this prior art has achieved a reduction in the size by adopting the face down process. Fig. 19 shows a schematic sectional view of a package of a surface acoustic wave filter element accommodated by using this face down process.

In the surface acoustic wave filter device 601, a surface acoustic wave filter element 603 is accommodated in a package 602. The package 602 includes a base board 602a, a side wall 602b, and a cap 602c.

On the base board 602a, there is formed a die-attach portion 602d having a plurality of electrode pads electrically connected to the surface acoustic wave filter element 603. The surface acoustic wave filter element 603 has a piezoelectric substrate 603a, and electrodes for constructing surface acoustic wave filter element are formed on the bottom surface of the piezoelectric substrate 603a. The electrodes formed on the bottom surface of the piezoelectric substrate 603a are electrically connected to the electrode pads in the die-attach portion 602d via bumps 604, and the surface acoustic wave filter element 603 is mechanically fixed to the die-attach portion 602d by the bumps 604.

Since such a face down process, that is, in a method of bonding a surface where electrodes constituting a surface acoustic wave filter element of the piezoelectric substrate is formed to a package by bumps, since no bonding wire is required, a small surface acoustic wave filter device can be produced.

As disclosed in the Japanese Unexamined Patent Application Publications Nos. 05-183380 and 10-93382, when an inductance is added to a series arm resonator or a parallel arm resonator in a surface acoustic wave filter device having a ladder type circuit, the filter characteristics thereof are improved. Also, in connecting a surface acoustic wave filter element and the electrodes on a package by a bonding wire, the above-described inductance can be added utilizing the bonding wire.

However, in the surface acoustic wave filter device 601, which is packaged by above-described face down process, since no bonding wire is provided, an inductance component can not be added to the surface acoustic wave filter device 601 by the bonding wire it is possible to obtain a small inductance component by rooting electrodes connecting the external electrodes provided on the package and the die-attach portion, but a large inductance can not be obtained by such rooting electrodes.

Therefore, in the surface acoustic wave filter device disclosed in the Japanese Unexamined Patent Application Publication No. 04-65909, it has been difficult to achieve the widening of pass band and the increase in attenuation value in the vicinity of a pass band, by the addition of inductance.

The Japanese Unexamined Patent Application Publication No. 04-65909 describes that, by adding inductance components between each of the input/output signal terminals and the ground terminal in the package, an input/output impedance matching can be achieved without using external elements. This description, however, is pertinent to a surface acoustic wave filter having a structure which must achieve an input/output impedance matching outside the surface acoustic wave filter. Accordingly, in the case of a surface acoustic wave filter having a ladder circuit configuration which intrinsically needs not be matched to be 50 Ω, it is unnecessary to achieve an impedance matching between each of the input/output signal terminals and the ground terminal in such a package.

Also, in the Japanese Unexamined Patent Application Publication No. 04-65909, inductance components are formed in the die-attach portion, but with this structure, an electromagnetic coupling occurs between the wiring and the like and the die-attach portion on the piezoelectric substrate of the surface acoustic wave filter element, so that the filter characteristics thereof deteriorate. In addition, it is necessary to adjust the position and the number of bumps to fix and electrically connect the surface acoustic wave filter element and the package, in order to form inductance component in the die-attach portion. However, since the position and the number of bumps do not necessarily achieve the sufficient electrical connections and mechanical bonding, reliability of surface acoustic wave filter device deteriorates.

JP 2000-223989 A describes a surface acoustic wave device comprising a comb-shaped electrode being an exciting electrode for a surface acoustic wave and extracting electrodes being input-output conductor patterns on the lower face of a piezoelectric substrate. A protective film is formed in a lower part of the electrodes. The surface acoustic wave device is constructed by arranging a surface acoustic wave element with the electrode formed on the lower face of the substrate on the lower face of the piezoelectric plate, and the extracting electrodes are capacitively coupled through the film to first and second electrodes of the surface acoustic wave device, and the exciting electrode is capacitively coupled through the film to a third electrode of the surface acoustic wave device. The third electrode is connected to the first electrode and to the second electrode by respective coil patterns formed in the surface acoustic wave device.

EP 0 853 381 A2 describes a surface acoustic wave filter having a surface acoustic wave filter element and a package for holding the surface acoustic wave filter element. The surface acoustic wave filter element includes a plurality of series arm resonators and first, second and third parallel arm resonators each formed on a piezoelectric substrate so as to form a ladder-type circuit. The first and second parallel arm resonators are close to input and output terminals of the filter element, respectively. Reference potential electrodes of the first and second parallel arm resonators are electrically connected to first and second electrode lands which are provided on the package and electrically isolated with each other while a reference potential electrode of the third parallel arm resonator is short-circuited with the reference potential electrode of either the first or second parallel arm resonator within the package.

EP 0 541 284 A1 describes a SAW filter that includes a first SAW resonator having a pair of terminals in a parallel arm of the SAW filter. A second SAW resonator has a pair of terminals and is provided in a series arm of the SAW filter. An inductance element formed by a micro string line in the package is connected in series to the first SAW resonator.

EP 0 897 218 A2 describes a surface acoustic wave filter having a ladder type filter circuit including a plurality of series arm resonators and a plurality of parallel arm resonators. The length of a bonding wire connecting the parallel arm resonator having a large electrostatic capacitance to ground is greater than that of a bonding wire connecting the another of the parallel arm resonators not having the large electrostatic capacitance to ground.

JP 10-093382 A describes a SAW filter having a signal line separated from the input pad of a chip through bonding from the input part of a package. A resonator sends the signal to the output terminal of the package by wire bonding.

### Summary of the Invention

It is the object of the present invention to overcome the above-described drawbacks of the prior art, and to provide a surface acoustic wave filter device with excellent filter characteristics, in which a surface acoustic wave filter element having a ladder type circuit is accommodated in a package by means of the face down process.

This object is achieved by a surface acoustic wave filter device according to claim 1.

According to the invention, inductances obtained by one or more microstrip lines are added to parallel arm resonators so that a deterioration of filter characteristics by the electromagnetic coupling between the electrodes on the surface acoustic wave filter element and the inductances provided in the package hardly occurs. The limitations on the position and the number of bumps is low.

In accordance with a more restrictive aspect of the present invention, a further microstrip line is connected between the electrode pad connected to the signal terminal of the series arm resonator and the external electrode connected to the signal line outside the surface acoustic wave filter device.

In accordance with another particular aspect of the present invention, the surface acoustic wave filter device in accordance with the present invention comprises at least two parallel arm resonators. In this surface acoustic wave filter device, the ground terminals of all the parallel arm resonators are commonly connected on the piezoelectric substrate, and the microstrip line is connected between the portion where the ground terminals of the parallel arm resonators are commonly connected and the external electrode provided in the package.

In accordance with still another particular aspect of the present invention, the surface acoustic wave filter device in accordance with the present invention comprises at least two parallel arm resonators. In this surface acoustic wave filter device, the package-side electrode pads connected to the ground terminals of all the parallel arm resonators, are made a common electrode pad, and the microstrip line is provided on the path between the common electrode pad and the external electrode.

In accordance with still another restrictive aspect of the present invention, the surface acoustic wave filter device in accordance with the present invention comprises at least three parallel arm resonators; and an electrode land which is provided on the piezoelectric substrate, and to which the ground terminals of at least two parallel arm resonators are each connected. In this surface acoustic wave filter device, the microstrip line is provided on the path between the electrode land connected to the ground terminals of at least two parallel arm resonators and the external electrode to which the electrode land is connected; and the parallel arm resonator other than the above-described at least two parallel arm resonators is electrically isolated from the above-described at least two parallel arm resonators on the piezoelectric substrate, and is electrically connected to the external electrode other than the package-side external electrode connected to the above-described at least two parallel arm resonators.

In accordance with a further particular aspect of the present invention, the surface acoustic wave filter device in accordance with the present invention comprises at least three parallel arm resonators. In this surface acoustic wave filter device, the plurality of electrode pads include a common electrode pad connected to the ground terminals of at least two parallel arm resonators among the parallel arm resonators, and the microstrip line is provided on the path between the common electrode pad and the external electrode to which the common electrode pad is connected; and the parallel arm resonator other than the above-described at least two parallel arm resonators is electrically isolated from the above-described at least two parallel arm resonators, at a die-attach portion including the plurality of electrode pads, and is electrically connected to the external electrode other than the package-side external electrode connected to the above-described at least two parallel arm resonators.

In accordance with a yet further particular aspect of the present invention, the above-described package comprises a base board on which the surface acoustic wave filter element is mounted; an annular side wall provided on the base board; and a cap member attached to the annual side wall so as to close the upper end thereof. Herein, a main portion of the microstrip line is disposed between the side wall and the base board.

In accordance with another particular aspect of the present invention, the above-described package comprises a first case member on which the surface acoustic wave filter element is mounted
. Herein, a main portion of the microstrip line is provided inside the first case member.

Here, "a main portion of a microstrip line" refers to at least 50% of the entire length of a microstrip line.

In accordance with still another particular aspect of the present invention, the signal terminal at the input/output end of the surface acoustic wave filter element and at least one ground terminal thereof are arranged so as to be rotated by 90° about the imaginary line which passes the center of the piezoelectric substrate of the surface acoustic wave filter element, and which is perpendicular to the piezoelectric substrate, with respect to the external electrode connected to the signal line at the input/output end and the external electrode connected to at least one ground potential among the plurality of external electrodes.

The communication device in accordance with the present invention is characterized by comprising a surface acoustic wave filter device in accordance with the present invention.

### Brief Description of the Drawings

Fig. 1 is a schematic sectional view of a surface acoustic wave filter device in accordance with a first embodiment of the present invention.
Fig. 2 is a plan view showing an electrode structure of a surface acoustic wave filter element used in the surface acoustic wave filter device in accordance with the first embodiment of the present invention.
Fig. 3 is a schematic plan view showing a die-attach portion including a plurality of electrode pads on the top surface of a base board in a package of the surface acoustic wave filter device in accordance with the first embodiment of the present invention.
Fig. 4 is a circuit diagram of the surface acoustic wave filter device in accordance with the first embodiment.
Fig. 5 is a plan view showing an electrode pattern on the top surface of the base board in the package of a conventional surface acoustic wave filter device prepared for comparison.
Fig. 6 is a diagram showing the attenuation value - frequency characteristics relationships in the surface acoustic wave device of the first embodiment and that of the conventional example.
Fig. 7 is a circuit diagram of a surface acoustic wave filter device in accordance with a second embodiment of the present invention.
Fig. 8 is a plan view showing an electrode structure on the top surface of a base board in a package used in a surface acoustic wave filter device in accordance with the second embodiment.
Fig. 9 is a diagram showing the attenuation value - frequency characteristics relationships in the surface acoustic wave filter device of the second embodiment and that of the conventional example.
Fig. 10 is a circuit diagram of a surface acoustic wave filter device in accordance with a third embodiment of the present invention.
Fig. 11 is a plan view showing an electrode structure on the top surface of a base board in a package used in a surface acoustic wave filter device in accordance with the third embodiment.
Fig. 12 is a diagram showing the attenuation value - frequency characteristics relationships in the surface acoustic wave filter device of the third embodiment and that of the conventional example.
Fig. 13 is a circuit diagram of a surface acoustic wave filter device in accordance with a fourth embodiment of the present invention.
Fig. 14 is a schematic sectional view of a surface acoustic wave filter device in accordance with the fourth embodiment of the present invention.
Fig. 15 is a plan view showing an electrode structure on the top surface of a base board in a package used in a surface acoustic wave filter device in accordance with the fourth embodiment.
Fig. 16 is a plan view showing the electrode structure within the base board in the package used in the surface acoustic wave filter device in accordance with the fourth embodiment of the present invention.
Fig. 17 is a diagram showing the attenuation value - frequency characteristics relationships in the surface acoustic wave filter device of the fourth embodiment and that of the conventional example.
Fig. 18 is a circuit diagram showing an example of a surface acoustic wave filter device having a conventional ladder type circuit.
Fig. 19 is a sectional view showing another example of a conventional surface acoustic wave filter device.

### Best Mode for Carrying Out the Invention

Hereinafter, the surface acoustic wave filter device in accordance with the present invention will be described in detail with reference to the drawings.

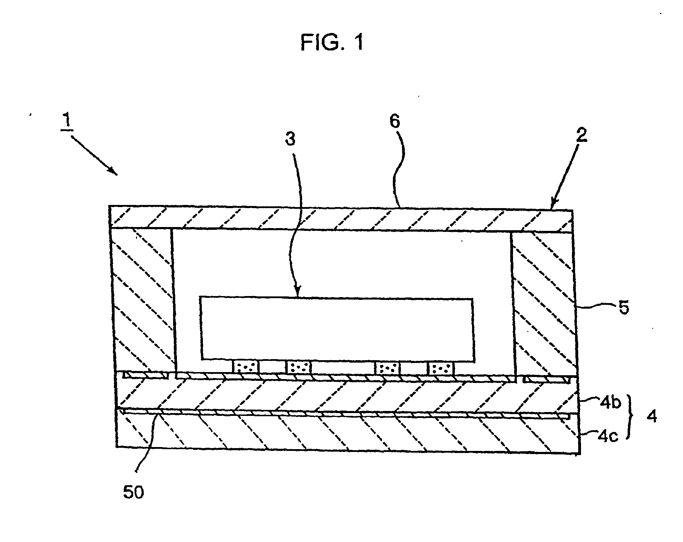

As shown in Fig. 1, the surface acoustic wave filter device 1 in accordance with the present embodiment includes a package 2, and a surface acoustic wave filter element 3 accommodated in a package 2. Fig. 1 only schematically shows an appearance of the surface acoustic wave filter device 3.

The package 2 comprises a base board 4 having a rectangular plate shape, a rectangular frame-shaped side wall 5 bonded on the base board 4, and a rectangular plate-shaped cap member 6 affixed to the side wall 5 so as to close the upper opening thereof. The side wall 5 does not necessarily requires to be rectangular, but may have a ringshaped structure such as annular shape.

The base board 4 and the side wall 5 may be made of an insulative ceramic such as alumina, or a synthetic resin. The cap member 6 may also be made of a similar material. Alternatively, the cap member 6 may be made of a metal or the like in order to have an electromagnetic shielding property.

The base board 4 is constructed by a multilayer substrate including substrates 4b and 4c. Between the substrate 4c and the substrate 4b, a ground electrode 50 for microstrip line which is described later is provided on a substantially entire surface of the substrate 4b. The substrates 4b and 4c are made of insulative material and have a predetermined dielectric constant.

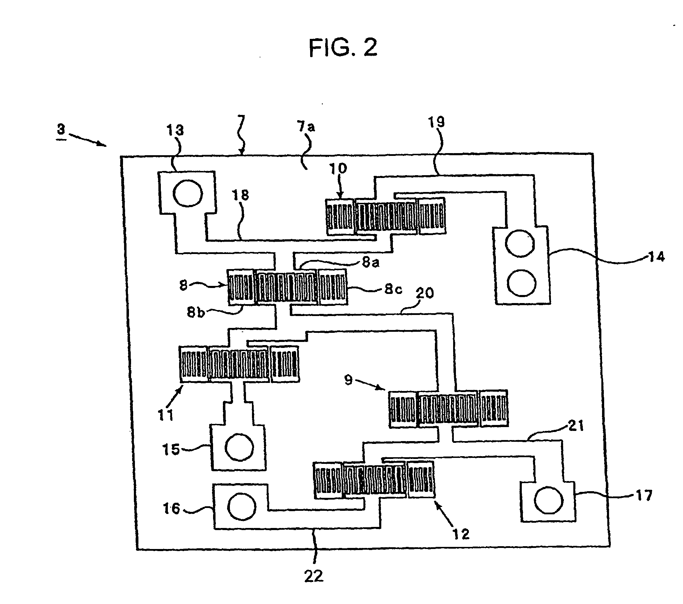

As shown in Fig. 2, the surface acoustic wave filter element 3 has a rectangular plate-shaped piezoelectric substrate 7 as a piezoelectric substrate. In this embodiment, the piezoelectric substrate 7 is made of a 36°, Y-cut, and X-propagation LiTaO₃ substrate. The piezoelectric substrate 7, however, may be made of another piezoelectric single crystal, or a piezoelectric ceramic such as lead titanate zirconate-based ceramic. Alternatively, a piezoelectric substrate constructed by forming a piezoelectric thin film made of ZnO or the like, on a piezoelectric plate or an insulating substrate, may be employed.

A metallic film is formed over the entire top surface 7a of the piezoelectric substrate 7, and then an electrode pattern shown in the figure is formed by the photolithography and etching. A metallic material for forming the electrode pattern is not particularly limited, but in this embodiment, aluminum is used as a metallic material. The formation of an electrode may also be performed using the lithography and lift off method.

The above-described electrode pattern will be described with reference to Fig. 2.

On the top surface 7a of the piezoelectric substrate 7, in order to implement a ladder circuit, series arm resonators 8 and 9 and parallel arm resonators 10 to 12 each of which includes one terminal pair surface acoustic wave element are formed. Each of the series arm resonators 8 and 9 and the parallel arm resonators 10 to 12 has one IDT and reflectors disposed on the opposite sides of each the IDTs in the propagation direction of a surface acoustic wave. Taking the series arm resonator 8 as a representative example, the series arm resonator 8 includes an IDT 8a and a pair of reflectors 8b and 8c.

Also, on the top surface 7a of the piezoelectric substrate 7, electrode lands 13 to 17 are formed. Each of the electrode lands 13 to 17 is a portion for electrically connecting the surface acoustic wave filter element 3 to the outside, and is formed of a metallic film having an area to a certain extent. Here, the circular portions drawn in the electrode lands 13 to 17 represent the portions to be bonded by the bumps.

The electrode lands 13 is used as the input end of the surface acoustic wave filter element 3, and is connected to one end of the first series arm resonator 8 via a conductive path 18. The conductive path 18 electrically connects the electrode land 13, the one end of the series arm resonator 8, and one end of the first parallel arm resonator 10. An end of the parallel arm resonator 10 which is opposite to the end thereof connected to the conductive path 18 is connected to the electrode land 14 via a conductive path 19. The electrode land 14 is an electrode land connected to the ground potential.

Also, an end of the series arm resonator 8 which is opposite to the end thereof connected to the conductive path 18 is connected to a conductive path 20. The conductive path 20 is connected to one end of the second series arm resonator 9 and also to one end of the second parallel arm resonator 11. An end of the second parallel arm resonator 11 which is opposite to the end thereof connected to the conductive path 20 is connected to an electrode land 15. The electrode land 15 is an electrode land connected to the ground potential.

A conductive path 21 is connected to the other end of the second series arm resonator 9. The conductive path 21 is also connected to the electrode land 17 and one end of the third parallel arm resonator 12. The electrode land 17 is used as an output terminal. An end of the parallel arm resonator 12 which is opposite to the end thereof connected to the conductive path 21 is connected to an electrode land 16 via a conductive path 22. The electrode land 16 is an electrode land connected to the ground potential.

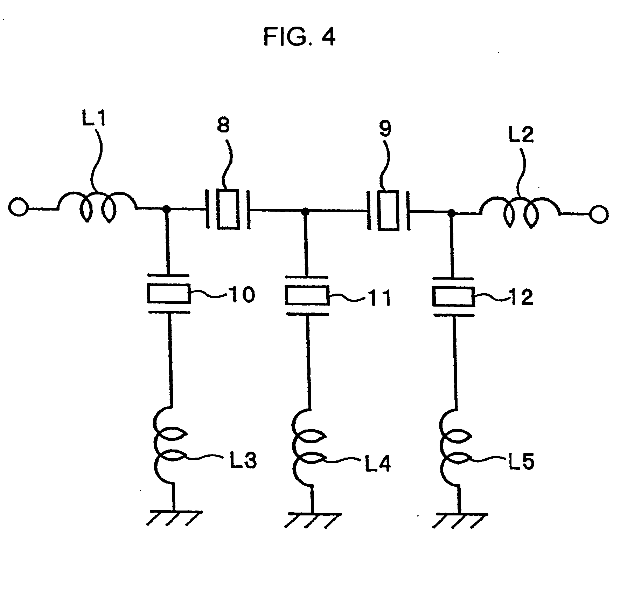

In the surface acoustic wave filter element 3, therefore, the above-described first and second series arm resonators 8 and 9, and the first to third parallel arm resonators are connected so as to define a ladder circuit shown in Fig. 4. Meanwhile, inductances L1 to L5 in Fig. 4 will be described later.

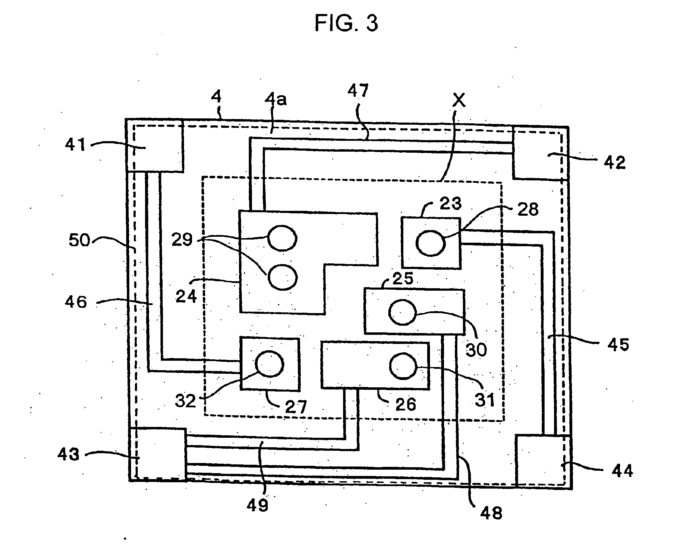

Fig. 3 illustrates the electrode structure formed on the top surface of the base board 4 in the package 2 shown in Fig. 1.

The surface acoustic wave filter element 3 is mounted on the portion indicated by a broken line X on the top surface 4a of the base board 4. At this portion, the above-described surface acoustic wave filter element 3 is bonded by bumps in a manner such that the top surface 7a of the piezoelectric substrate 7 is placed face down. More specifically, the surface acoustic wave filter element 3 shown in Fig. 2 is superposed on the top surface 4a of the base board 4 shown in Fig. 3, in a manner such that the top surface 7a of the piezoelectric substrate 7 is placed face down, and the surface acoustic wave filter element 3 and the base board 4 are bonded by bumps, thereby fixing the surface acoustic wave filter element 3.

On the top surface 4a of the base board 4, electrodes shown in the figure are formed by printing and firing electrode paste. The plurality of electrode pads 23 to 27 define a die-attach portion. The electrode pads 23 to 27 are formed separately from one another. Among these, the electrode pad 23 is electrically connected to the electrode land 13 shown in Fig. 2 and mechanically bonded thereto, by a bump 28. Likewise, the electrode pads 24 to 26 are connected to the electrode lands 14 to 16 shown in Fig. 2, respectively, by bumps 29, 30, and 31. Also, the electrode pad 27 is electrically connected to the electrode land 17 shown in Fig. 2 via a bump 32.

Among the above-described electrode pads 23 to 27, the electrode pads 23 and 27 are electrodes each connected to an external signal line, while the electrode pad 24 and 26 are electrodes each connected to an external ground line.

External electrodes 41 to 44 are formed on the top surface of the base board 4. The external electrodes 41 to 44 are formed not only on the top surface 4a of the base board 4, but also so as to extend to the bottom surface and the side surfaces thereof, at portions which are not shown in Fig. 1. Each of the external electrodes 41 to 44 thus performs the function of an electrode for electrically connecting the surface acoustic wave filter device 1 to the outside.

The external electrode 44 is connected to the electrode pad 23 via a microstrip line 45. Likewise, the external electrode 41 is connected to the electrode pad 27 via a microstrip line 46. Also, the external electrode 42 is connected to the electrode pad 24 via a microstrip line 47, and the external electrode 43 is connected to both electrode pads 25 and 26 via microstrip lines 48 and 49, respectively.

The external electrodes 42 and 43 are, therefore, external electrodes each connected to an external ground line, while the external electrodes 41 and 44 are external electrodes each connected to a signal line.

The above-described microstrip lines 45 to 49 are opposite to the ground electrode 50 via the substrate 4b, as indicated by broken line in Fig. 3. Fine belt-shaped conductive patterns function as microstrip lines. In Fig. 3, though the ground electrode 50 is provided on a substantially entire surface of the substrate 4b, ground electrode 50 may be formed at portions opposite to the microstrip lines 45 to 49. The above-described microstrip lines 45 to 49 located between the base board 4 and the side wall.

In this embodiment, inductance components are obtained by the above-described microstrip lines 45 to 49. Specifically, an inductance L1 shown in Fig. 4 is defined by the microstrip line 45, an inductance L2 is defined by the microstrip line 46, and inductances L3 to L5 are defined by the microstrip lines 47 to 49, respectively.

In other words, inductance components of the microstrip lines 47 to 49 are each connected between parallel arm resonators having a ladder circuit, and the external electrodes each connected to the ground line. Likewise, inductance components of the microstrip lines 46 and 45 are each connected between series arm resonators and the external electrodes 41 and 44 each connected to the external signal line, respectively.

In this embodiment, in the surface acoustic wave filter device including a ladder type filter circuit comprising two series arm resonators 8 and 9 and three parallel arm resonators 10 to 12, inductance components are independently added into the parallel arm resonators 10 to 12 by the above-described microstrip lines 47 to 49, respectively. This allows the widening of pass band and the increase in attenuation value in the vicinity of pass band. This will be described based on specific experimentation.

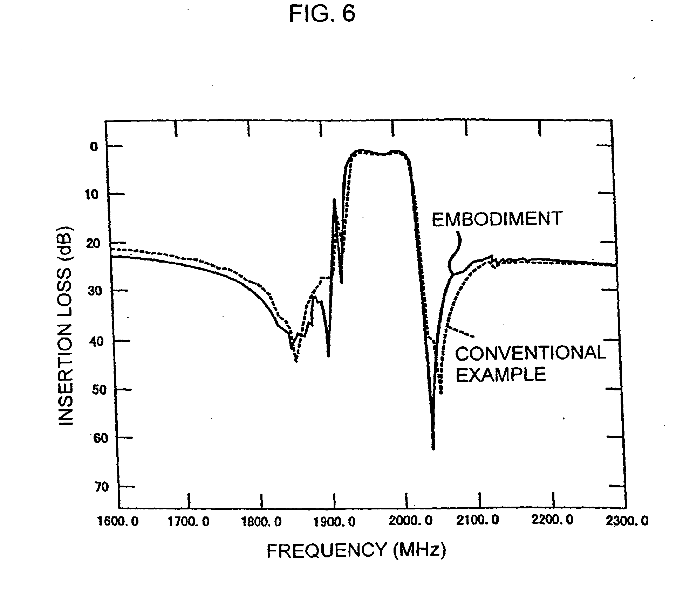

The solid line in Fig. 6 shows the attenuation value - frequency characteristics relationship of the surface acoustic wave filter device in accordance with the present invention, and the broken line shows that of a surface acoustic wave filter device prepared for comparison.

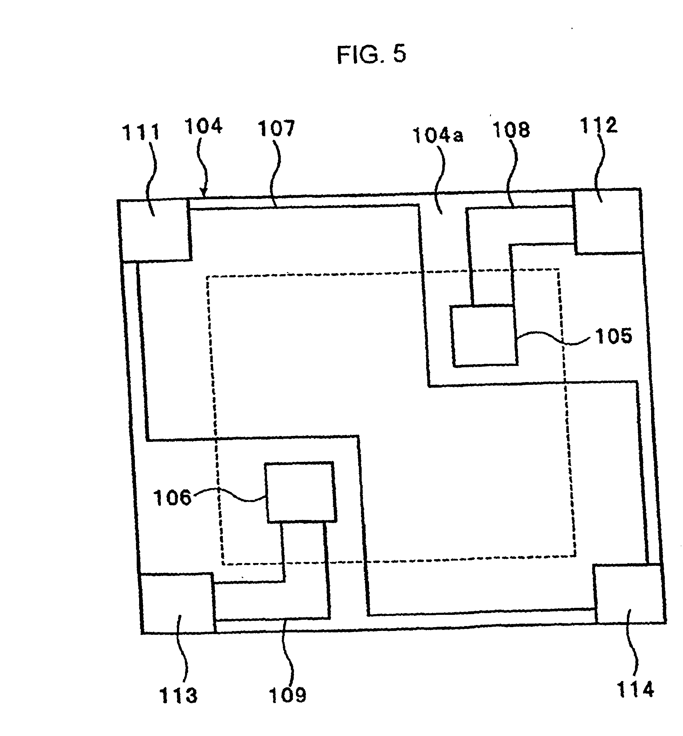

The conventional surface acoustic wave filter device, the results of which are shown in Fig. 6 by the broken line, is the same as that of the above-described embodiment except that the electrode structure on the top surface of the base board of the package has been formed as shown in Fig. 5. That is, electrode pads 105 to 107 are formed on the top surface 104a of a base board 104. External electrodes 111 to 114 are formed at the four corners. The external electrodes 111 to 114 are formed so as to extend from the top surface to the bottom surface through the side surfaces thereof. These external electrodes corresponds to the portions which are electrically connected to the outside. The external electrodes 112 and 113 are electrically connected to the electrode pads 105 and 106 via wide conductive paths 108 and 109, respectively.

Since ground electrodes are not formed on portions of the base board 104 which is opposite to the conductive paths 108 and 109, the conductive paths 108 and 109 do not function as microstrip lines. An electrode pad 107 having a large area is directly connected to external electrodes 111 and 114. The electrode pad 107 is bonded via bumps to the electrode lands 14 to 16 of the surface acoustic wave filter element 3 each connected to the ground line, and the electrode pads 105 and 106 are the portions to be connected to the respective electrode lands 13 and 17 each connected to a signal terminal.

Therefore, in the conventional surface acoustic wave filter device prepared for comparison, there are no microstrip lines independently formed between the parallel arm resonators 10 to 12 and the external electrodes 111 and 114 each connected to a ground line, therefore, inductance components by microstrip lines are not inserted therebetween. Likewise, there are no microstrip lines connected between the series arm resonators 8 and 9 and the external electrodes 112 and 113, respectively, on the package side, therefore, inductance components by microstrip lines are not inserted therebetween.

The specifications of the surface acoustic wave filter element 3 used in the above-described embodiment and the conventional example are as follows:
The series arm resonators 8 and 9 ...... interdigital width of electrode fingers = 17 µm, number of pairs of electrodes in an IDT = 100, number of electrode fingers in a reflector = 100, and electrode finger pitch = 0.99 µm (wavelength of surface acoustic wave λ = 1.99 µm).

The first and third parallel arm resonators 10 and 12 ...... interdigital width of electrode finger = 50 µm, number of pairs of electrodes in an IDT = 40, number of electrode fingers in a reflector = 100, and electrode finger pitch = 1.04 µm (wavelength of surface acoustic wave λ = 2.07 µm).

The second parallel arm resonators 11 ...... interdigital width of electrode finger = 52 µm, number of pairs of electrodes in an IDT = 90, number of electrode fingers in a reflector = 100, and electrode finger pitch = 1.04 µm (wavelength of surface acoustic wave λ = 2.08 µm).

In the embodiment, the inductance components by the microstrip lines 45 to 49 formed on the base board 4, are as follows:

| | |
|---|---|
| Microstrip lines 45 and 46 | 0.8 nH |
| Microstrip lines 47 and 49 | 0.8 nH |
| Microstrip line 48 | 0.5 nH |

As can be seen from Fig. 6, the width of the pass band corresponding to an attenuation value of 4 dB, is 86 MHz for this embodiment, in contrast to 78 MHz for the conventional example, that is, this embodiment exhibits a wider pass band width than the conventional example. The attenuation pole in the vicinity of the pass band, in this embodiment, is positioned at substantially the same frequency as that in the conventional example. This would be because there exists no common inductance component since the electrode pads of the die-attach portion connected to the ground potential are separated from one another, in other words, since inductance components are independently added to the first to third parallel arm resonators 10 to 12 by the above-described microstrip lines 47 to 49.

Furthermore, it will be recognized that, since the microstrip lines 45 to 49 for adding the above-described inductance components exist between the base board and the side wall, the electromagnetic coupling between each of the microstrip lines 45 to 49 and the surface acoustic wave filter element 3 does not much occur, so that superior filter characteristics can be achieved. In addition, since the above-described microstrip lines 45 to 49 do not exist in the die-attach portion, there is no risk that these microstrip lines impose limitations on the position and the number of bumps. This allows the surface acoustic wave filter element 3 to be bonded to the base board 4 with a sufficient bonding strength.

Changing the dielectric constant of the substrate 4b on which the microstrip lines are provided, and the distance between the microstrip lines and the ground electrode 50 makes it possible to design the inductance component per unit length of the microstrip line. Therefore, necessary inductance component in order to improve the characteristics of surface acoustic wave filter can be designed and added into the surface acoustic wave filter with use of the inductance component of microstrip line. Further, since the microstrip line is resistant to the influence from outside, the inductance component of the microstrip line hardly changes even if the surface acoustic wave filter element is attached to the base board by face down process. Therefore desired inductance component is added to the surface acoustic wave filter to be in line with the design.

### (Second Embodiment)

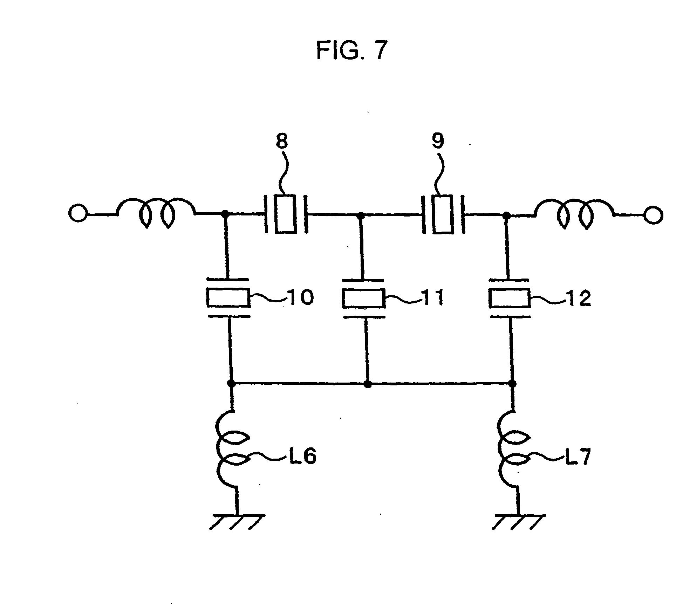

Fig. 7 is a diagram showing the circuit configuration of a surface acoustic wave filter device in accordance with a second embodiment of the present invention.

In this embodiment also, a surface acoustic wave filter element 3 similar to that in accordance with the first embodiment, is used. As shown in Fig. 7, two series arm resonators 8 and 9, and three parallel arm resonators 10 to 12 are connected to one another so as to have a ladder circuit configuration.

As seen from Fig. 7, however, in this embodiment, the ends of the three parallel arm resonators 10 to 12 connected to the ground potential are commonly connected, and inductances L6 and L7 are connected between this commonly connected portion and the external electrodes each connected to an external ground line. Here, the ends of the three parallel arm resonators 10 to 12 connected to the ground potential, that is, the ground terminals may commonly connected on the piezoelectric substrate.

Each of the above-described inductances L6 and L7 is defined by a microstrip line formed in the package.

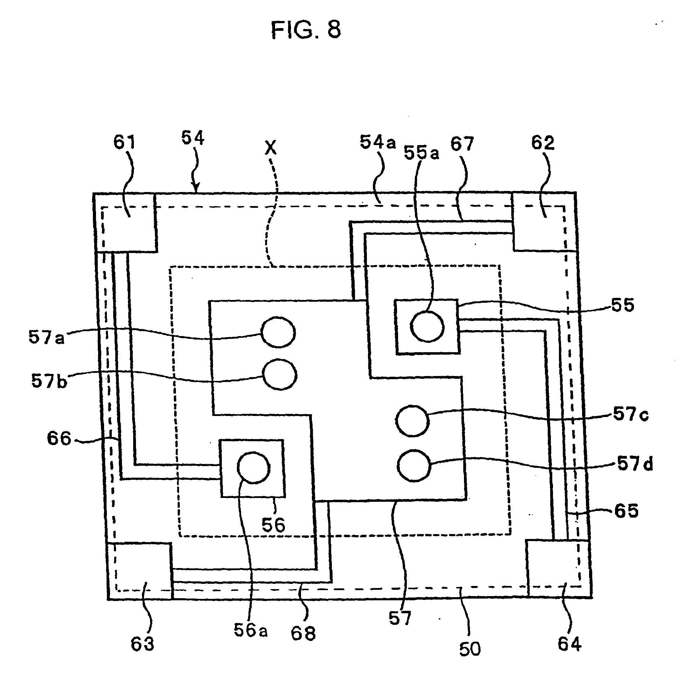

Fig. 8 is a plan view showing the electrode structure on the top surface of the base board 54 in the package used in the second embodiment.

The second embodiment is constructed in the same manner as the first embodiment except that the electrode structure on the top surface of the base board 54 of the second embodiment differs from that in the first embodiment. Hence, with regard to the structure of the surface acoustic wave filter element 3 and other structures of the package 2, the description of the first embodiment will be quoted.

In this embodiment also, the surface acoustic wave filter element 3 is bonded via bumps by means of the face down process, in a manner such that the top surface 7a (see Fig. 2) of the piezoelectric substrate 7 is placed face down on the area surrounded by broken line X on the top surface of the base board 54.

A die-attach portion including electrode pads 55 to 57 is formed on the top surface 54a of the base board 54. The electrode pads 55 and 56 are bonded to the electrode lands 13 and 17 shown in Fig. 2 via bumps 55a and 56a, respectively. The electrode pad 57 is bonded to the electrode lands 14, 15, and 16 connected to the ground potentials shown in Fig. 2, via bumps 57a to 57d.

As in the case of the first embodiment, external electrodes 61 to 64 are provided at the corner portions of the base board 54. The external electrodes 61 to 64 are formed not only on the top surface 54a of the base board 54, but also so as to extend to the bottom surface through the side surfaces thereof. The above-described electrode pads 55 and 56 are connected to the external electrodes 64 and 61 via microstrip lines 65 and 66, respectively. The electrode pad 57 is connected to the external electrodes 62 and 63 via the respective microstrip lines 67 and 68.

That is, the terminals of the three parallel arm resonators connected to the ground potential, via the electrode pad 57 in the die-attach portion of the package 2 are commonly connected, and the electrode pad 57 is connected to the different external electrodes 62 and 63 via the respective microstrip lines 67 and 68.

The electrode lands 13 and 17 defining input/output signal terminals and the electrode lands 14 to 16 defining ground terminals on the piezoelectric substrate 4, are arranged so as to be rotated by 90° about the normal line passing the center of the piezoelectric substrate 4, with respect to the external electrodes 61 and 64 each connected to the signal line and the external electrodes 62 and 63 each connected to the ground line outside the package.

As is similar with the first embodiment, the microstrip lines 65, 66, 67 and 68 are opposite to the ground electrode 50. Other constructions of the second embodiment are the same as those of the first embodiment.

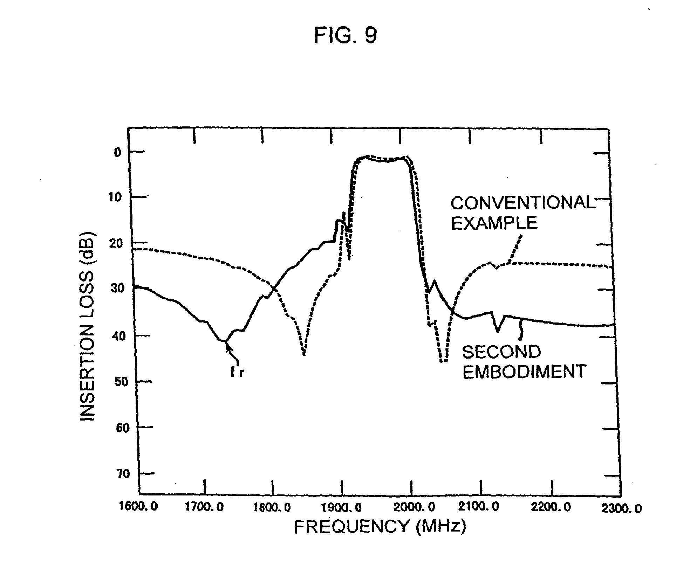

The attenuation value - frequency characteristics relationship of the surface acoustic wave filter device in accordance with the second embodiment is indicated by a solid line in Fig. 9. For comparison, the attenuation value - frequency characteristics relationship of the surface acoustic wave filter device in accordance with a conventional example prepared as a comparative example used in the first embodiment, is indicated by a broken line.

In the embodiment, each of the inductance components added by the microstrip lines 65 and 66 is set to 0.8 nH, and each of the inductance components added by the microstrip lines 67 and 68 is set to about 0.3 nH.

Actually, however, this results in that a common inductance of about 0.1 nH is inserted, since the microstrip lines 67 and 68 connected to the external electrodes 62 and 63 each connected to an external ground line, are connected in parallel with the external ground lines.

As can be seen from Fig. 9, in this embodiment, since inductance components are added in the package 2 by the above-described microstrip lines 65 to 68, the attenuation value in the vicinity of the pass band is increased. The width of the pass band corresponding to an attenuation value of 4 dB, is 80 MHz for this embodiment, in contrast to 78 MHz for the conventional example, that is, the widening of pass band is simultaneously realized in this embodiment.

In this embodiment also, since microstrip lines for adding inductances exist between the base board 4 and the annular side wall 5, the electromagnetic coupling with the surface acoustic wave filter element is low, thereby providing superior filter characteristics. Furthermore, as in the case of the first embodiment, in this embodiment also, since no microstrip lines exist in the die-attach portion, there is no limitations on the position and the number of bumps. This enables the surface acoustic wave filter element 3 to be securely bonded to the base board 4.

### (Third Embodiment)

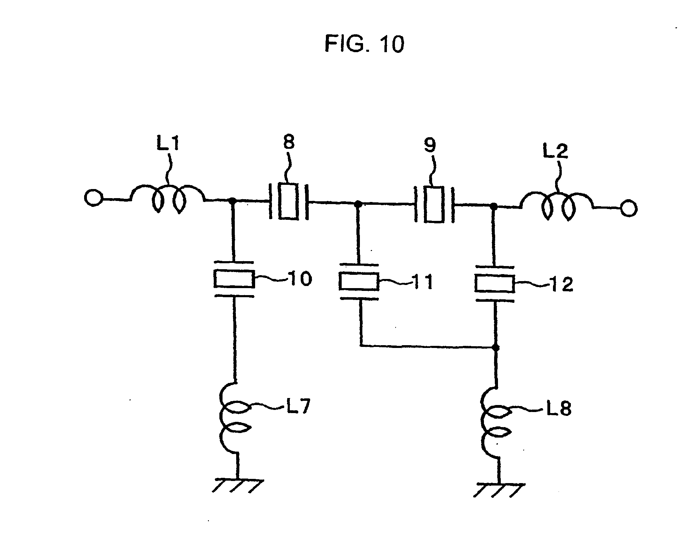

Fig. 10 is a diagram showing the circuit configuration of a surface acoustic wave filter device in accordance with a third embodiment of the present invention. In the third embodiment also, the surface acoustic wave filter element 3 is constructed in the same manner as the first embodiment, and two series arm resonators 8 and 9 and three parallel arm resonators 10 to 12 are connected to one another so as to implement a ladder circuit.

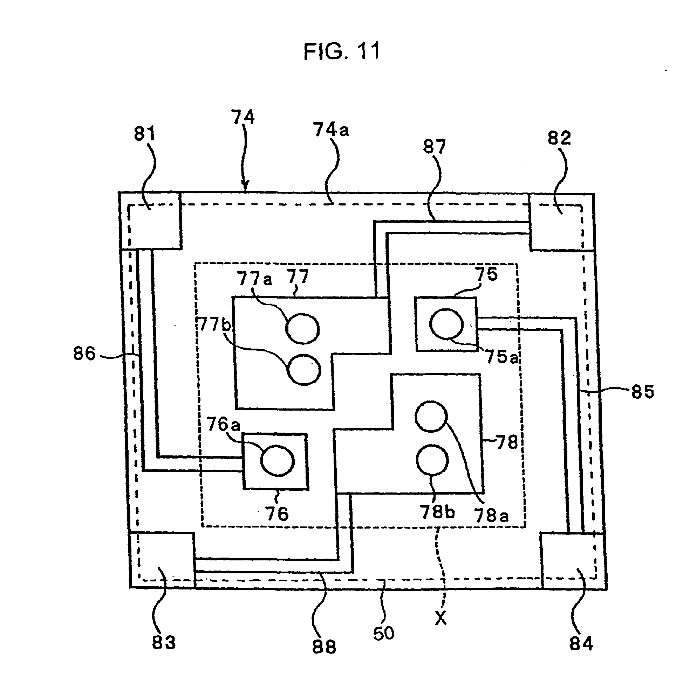

In this embodiment also, the side wall and the cap member of the package 2 are constructed in the same manner as those of the first embodiment. The difference between the third and first embodiments lies in the electrode structure provided on the base board 74, as shown in Fig. 11. Hence, with regard to structures other than the electrode structure on the base board 74, descriptions will not be repeated with reference to the description of the first embodiment.

On the top surface 74a of the base board 74, a plurality of electrode pads 75,76, 77, and 78 are formed, and a die-attach portion is defined by the plurality of electrode pads 75 to 78. The portion indicated by a circle or circles inside each of the electrode pads 75 to 78 represents the position of bump when the surface acoustic wave filter element 3 is bonded by means of the face down process.

External electrodes 81 to 84 are formed at the corners of the base board 74, as is similar with those in the first embodiment. The external electrodes 81 and 84 are external electrodes each connected to a signal line, and are connected to the electrode pads 76 and 75 via microstrip lines 86 and 85. The electrode pads 77 and 78 are connected to the external electrode 82 and 83 each connected to a ground line, via microstrip lines 87 and 88.

Also, the electrode pad 75 is connected to the electrode lands 13 shown in Fig. 2 via a bump 75a, and the electrode pad 76 is connected to the electrode land 17 shown in Fig. 2 via a bump 76a. The electrode pad 77 is connected to the electrode lands 14 (Fig. 2) via bumps 77a and 77b, and the electrode pad 78 is connected to the electrode lands 15 and 16 (see Fig. 2) via bumps 78a and 78b. Herein, ground terminals of at least two parallel arm resonators may be connected to one electrode land. In other words, electrode lands connected to the ground potential, for example, the electrode lands 15 and 16 may be made a common land.

As shown in Fig. 10, therefore, the first parallel arm resonator 10 and the second and third resonators 11 and 12 are separated from each other in the die-attach portion. An inductance L7 by the microstrip line 87 is defined between the first parallel arm resonator 10 and the external electrode 82 connected to an external ground line, and an inductance L8 by the microstrip line 88 is defined between the second and third parallel arm resonators 11 and 12 and the external electrode 83 connected to a ground line.

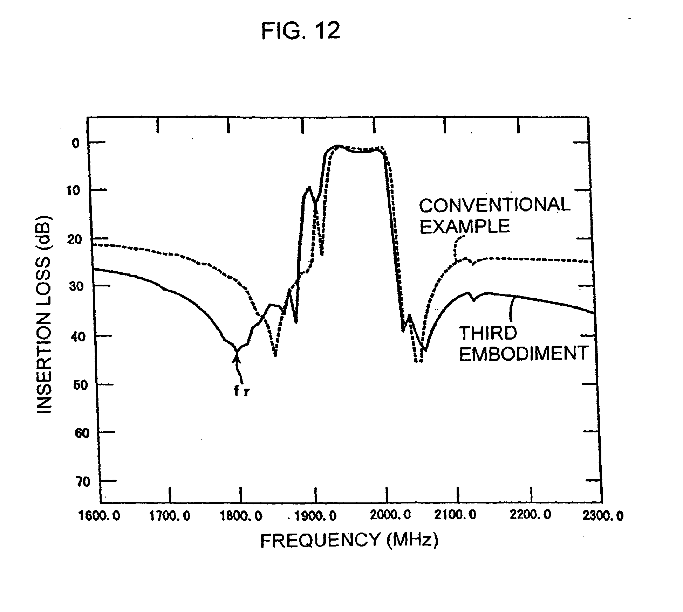

The attenuation value - frequency characteristics relationship of the surface acoustic wave filter device in accordance with the third embodiment is shown in Fig. 12 using a solid line. For comparison, the attenuation value - frequency characteristics relationship of the surface acoustic wave filter device in accordance with the conventional example prepared for comparison used in the first embodiment, is shown in Fig. 12 using a broken line.

In this case, each of the inductance components by the microstrip lines 85 and 86 was set to 0.8 nH, and each of the inductance components by the microstrip lines 87 and 88 was set to about 0.3 nH. Other constructions of this embodiment is similar to those of the first embodiment.

As can be seen from Fig. 12, in this embodiment also, the attenuation value in the vicinity of the pass band can be significantly increased over the conventional example, since inductance components are formed in the package 2 by the above-described microstrip lines 85 to 88. The width of the pass band corresponding to an attenuation value of 4 dB, is 85 MHz for this embodiment, in contrast to 78 MHz for the conventional example, that is, the widening of pass band is simultaneously realized in this embodiment.

As compared with the frequency characteristics (Fig. 9) of the second embodiment, in this embodiment, the frequency at the attenuation pole fr in the vicinity of the pass band is increased. Therefore, when an increase in the attenuation value in the frequency range nearer to the pass band is required, the surface acoustic wave filter device in accordance with the third embodiment is more advantageous than that in accordance with the second embodiment.

### (Fourth Embodiment)

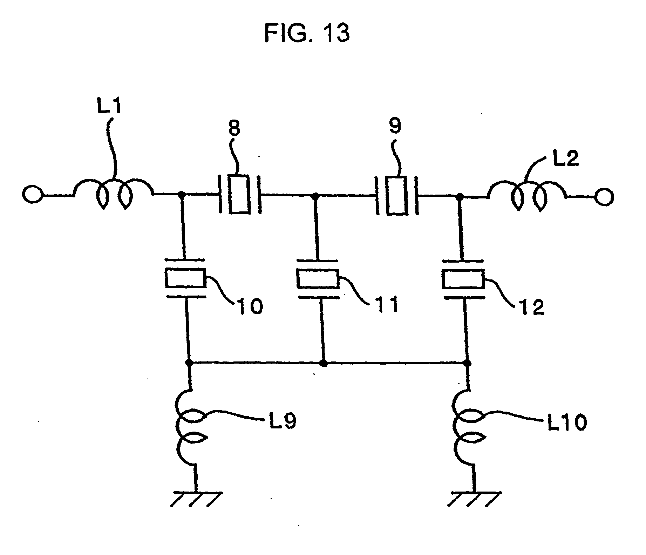

Fig. 13 is a diagram showing the circuit configuration of a surface acoustic wave filter device in accordance with a fourth embodiment of the present invention. In the fourth embodiment also, the same surface acoustic wave filter element 3 as that in accordance with the first embodiment is used, and first and second series arm resonators 8 and 9, and parallel arm resonators 10 to 12 are connected to one another so as to have a ladder circuit.

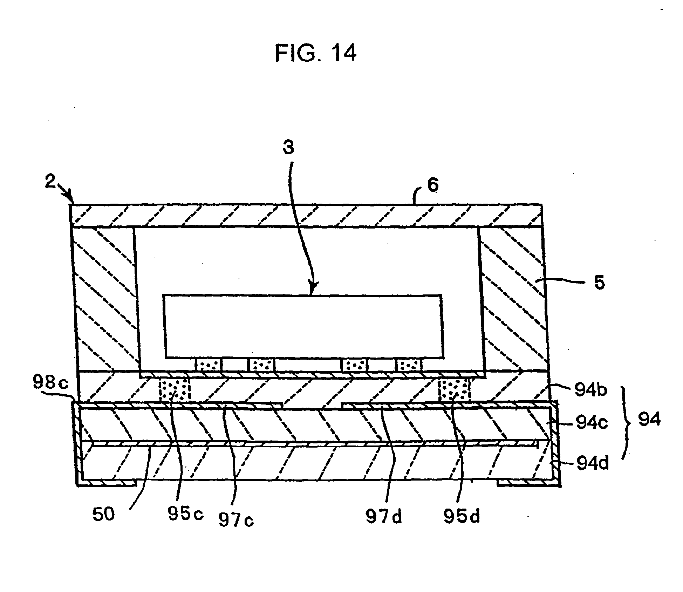

As shown in Fig. 14 as a sectional view, a package 2 includes a base board 94 as a first case member. Also, a second case member including a side wall 95 and a cap 96, is constructed as in the same manner as that in the first embodiment.

In this embodiment, the base board 94 is constructed by a laminated ceramic board including substrates 94b, 94c and 94d, and within the base board 94, microstrip lines for adding inductances as described later are formed.

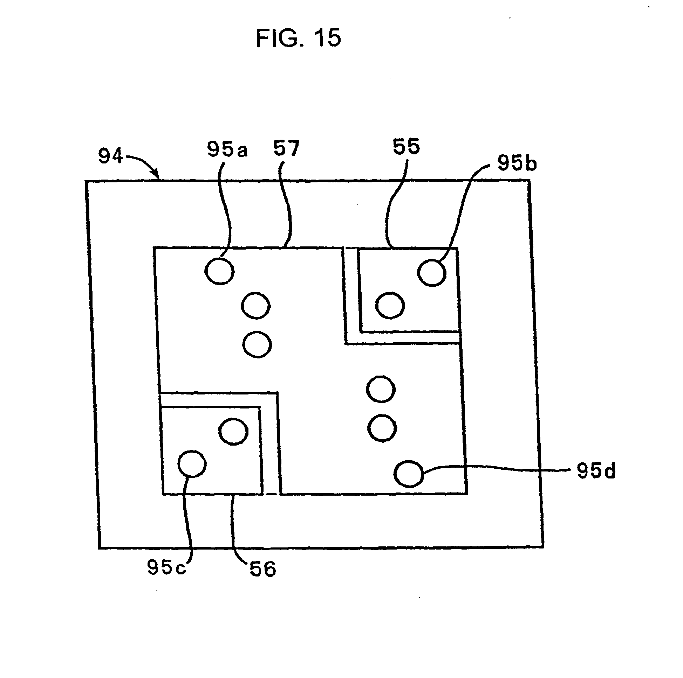

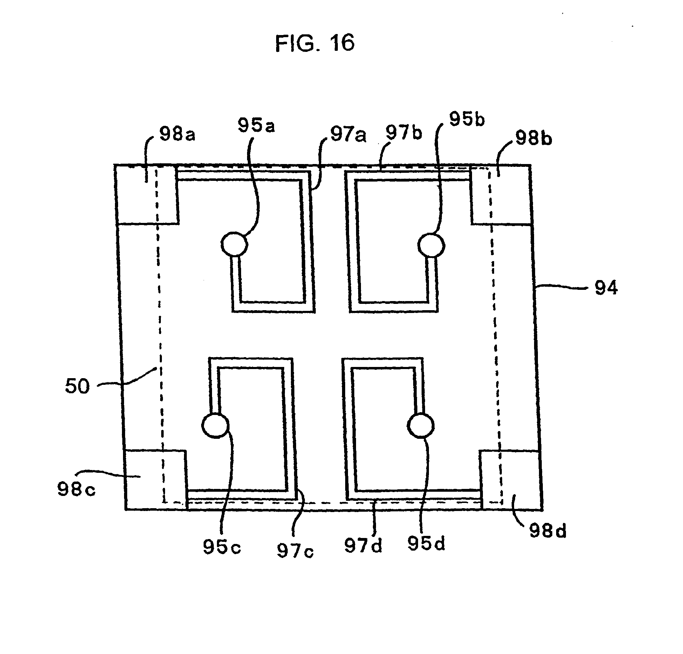

Fig. 15 is a plan view showing a top surface of the base board 94 and a top surface of the substrate 94b, and Fig. 16 is a plan view showing a top surface of the substrate 94c where microstrip lines are formed.

As shown in Fig. 15, electrode pads 55 to 57 are formed on the top surface of the base board 94, in the same manner as the base board in the second embodiment shown in Fig. 8. In this embodiment, however, no external electrode and microstrip line are formed on the top surface of the base board 94, and are provided inside the base substrate 94. Through hole electrodes 95a to 95d penetrating through the substrate 94b and reaching the bottom surface thereof are provided at the electrode pads 55 to 57. As shown in Fig. 16 the lower ends of the through hole electrodes 95a to 95d are connected to one-side ends of the microstrip lines 97a to 97d provided on the upper surface of the substrate 94c, respectively. The other ends of the microstrip lines 97a to 97d are connected to the external electrodes 98a to 98d on the upper surface of the substrate 94c, respectively. The external electrodes 98a to 98d are formed so as to extend from the corner portions to the bottom surface of the base board 94 through the side surfaces of the substrates 94c and 94d (see Fig. 14). Further, as indicated by broken line in Fig. 16, the ground electrode 50 for microstrip lines 97a to 97d is provided to cover the substantially entire bottom surface of the substrate 94c.

More specifically, in this embodiment, the microstrip lines 97a to 97d are embedded in the base board 94 as the first case member, and by these microstrip lines 97a to 97d, as shown in Fig. 13, inductance components L9 and L10 are defined between the portion where the first to third parallel arm resonators are commonly connected, and the external electrodes each connected to an external ground line, while inductance components L1 and L2 are defined between the series arm resonators 8 and 9 and the external electrodes each connected to an external signal line.

In this manner, the microstrip lines for adding inductances can be formed at any positions within the package.

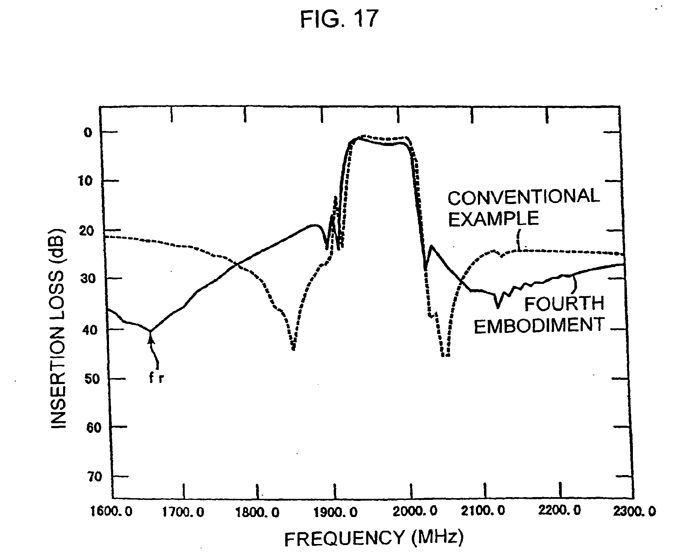

The solid line in Fig. 17 shows the attenuation value - frequency characteristics relationship of the surface acoustic wave filter device in accordance with the fourth embodiment, and the broken line shows the attenuation value - frequency characteristics relationship of the surface acoustic wave filter device in accordance with the conventional example prepared for comparison. Here, for forming the surface acoustic wave filter device in accordance with the fourth embodiment, the inductance component by a microstrip line added to each of the series arm resonators was set to 1.0 nH, and the inductance components L9 and L10 each connected between the parallel arm resonator and the ground line was set to 1.0 nH.

As can been seen from Fig. 17, in this embodiment also, a formation of microstrip lines for adding inductance components increases the attenuation value in the vicinity of the pass band. In particular, the improvement in the attenuation value on the lower frequency side is significant. This is because the frequency fr of the attenuation pole has become lower since the value of the inductances L9 and L10 connected in parallel with each other are large.

In the fourth embodiment, since the microstrip lines are embedded in the base board, that is, since the microstrip lines are formed as internal electrodes, each of the microstrip lines can be lengthened, thereby providing a larger inductance value. In order to obtain an even larger inductance value, it is preferable to lengthen a microstrip line by forming a plurality of layers of microstrip lines, and electrically connecting the plurality of microstrip lines with one another, by a through hole electrode or a via hole electrode.

As described above, in the surface acoustic wave filter device in accordance with the present invention, since inductance components by microstrip lines are each connected to at least any of the series arm resonators and parallel arm resonators constituting a ladder circuit, and the microstrip lines are disposed in the package, the attenuation value in the vicinity of the pass band is increased and wide-band filter characteristics can be achieved.

Changing the dielectric constant of the substrate on which the microstrip lines are provided, and the distance between the microstrip lines and the ground electrode makes it possible to design the inductance component per unit length of the microstrip line. Therefore, necessary inductance component in order to improve the characteristics of surface acoustic wave filter can be designed and added into the surface acoustic wave filter with use of the inductance component of microstrip line. Further, since the microstrip line is resistant to the influence from outside, the inductance component of the microstrip line hardly changes even if the surface acoustic wave filter element is attached to the base board by face down process. Therefore desired inductance component is added to the surface acoustic wave filter to be in line with the design.

When the package comprises a die-attach portion having a plurality of electrode pads each of which is connected to any one of the signal terminals and any one of the ground terminals of the surface acoustic wave filter element by the bumps; and a plurality of external electrodes each of which is electrically connected to any one of the electrode pads, and each of which is connected to a signal line or a ground line outside the surface acoustic wave filter device, the surface acoustic wave filter element can be reliably connected and mechanically bonded to the plurality of electrode pads using bumps by means of face down process. The present invention, therefore, allows a wide-band filter device which is large in the attenuation value outside the pass band to be easily formed.

When each of the microstrip lines is connected between the electrode pad connected to the signal terminal of the series arm resonator and the external electrode connected to the signal line outside the surface acoustic wave filter device, since each of the microstrip lines is connected between the series arm resonator and the signal line, the reflection loss can be reduced and the widening of pass band can be achieved.

When each of the above-described microstrip lines is provided between the electrode pad which is connected to the ground terminal of at least one parallel arm resonator by the bumps, and the external electrode which is connected to the ground line outside the package, the increase in attenuation value in the vicinity of the pass band and wide-band filter characteristics can be achieved.

When the surface acoustic wave filter device comprises at least two parallel arm resonators, wherein the ground terminals of all the parallel arm resonators are commonly connected, on the piezoelectric substrate, wherein each of the microstrip lines is connected between the portion where the ground terminals of the parallel arm resonators are commonly connected, and each of the external electrodes provided in the package, the attenuation value can be increased at lower frequency range.

Likewise, when the package-side electrode pads connected to the ground terminals of all the parallel arm resonators are made a common electrode pad, and each of the microstrip lines is provided on the path between the common electrode pad and each of the external electrodes, the attenuation value can be increased at lower frequency range, as well. In addition, making the electrode pads a common pad on the package side facilitates the wiring of chips.

When the surface acoustic wave filter comprises at least three parallel arm resonators, wherein microstrip lines are provided on the path between the electrode lands to which the ground terminals of at least two parallel arm resonators are connected, and the external electrodes to which these electrode lands are connected, and wherein the parallel arm resonators other than the above-described at least two parallel arm resonators are, on the piezoelectric substrate, electrically isolated from the above-described at least two parallel arm resonators, it is possible to obtain filter characteristics wherein more widening of pass band is achieved and simultaneously the attenuation value in the vicinity of the pass band is increased.

When the surface acoustic wave filter device comprises at least three parallel arm resonators; and a common electrode pad connected to the ground terminals of at least two parallel arm resonators among the parallel arm resonators, wherein each of the microstrip lines is provided on the path between the common electrode pad and the external electrodes to which the common electrode pad is connected, and wherein the other parallel arm resonators are electrically isolated from the above-described at least two parallel arm resonators, at a die-attach portion including a plurality of electrode pads, the attenuation value in the vicinity of the pass band is more increased, and wideband filter characteristics can be implemented.

When the microstrip lines are disposed, in the package, at the positions other than the position of the die-attach portion, the electromagnetic interference with the surface acoustic wave filter element, and consequently, the deterioration of filter characteristics is prevented.

When the package comprises a base board, an annular side wall provided on the base board, and a cap member affixed to the annual side wall so as to close the upper end thereof, wherein the main portion of each of the microstrip lines is disposed between the side wall and the base board, there is no need for extra space, so that filter characteristics can be improved without changing the size of the package.

When the package comprises the first case member on which the surface acoustic wave filter element is mounted, and the second case member enclosing the surface acoustic wave filter element mounted on the first case member, wherein the main portion of each of the microstrip lines is provided inside the first case member, it becomes possible to insert large inductance components, resulting in a significant improvement in filter characteristics.

When the signal terminals at the input/output ends of the surface acoustic wave filter element and at least one ground terminal thereof are disposed so as to be rotated by 90° around the imaginary line which passes the center of the piezoelectric substrate of the surface acoustic wave filter element, and which is perpendicular to the piezoelectric substrate, with respect to the external electrodes connected to the input/output end signal lines and at least one external electrode connected to the ground potential among the plurality of external electrodes, it becomes possible to insert large inductance components without making troublesome bending portions, when forming microstrip lines between the side wall and the base board.

### Industrial Applicability

The surface acoustic wave filter device according to the present invention, can be applied to various communication apparatuses and signal processing devices, in particular, to a small communication apparatus such as portable phone.

## Claims

1. A surface acoustic wave filter device, comprising:
a surface acoustic wave filter element (3) including a piezoelectric substrate (7) and a plurality of one terminal pair surface acoustic wave elements (8-12) provided on said piezoelectric substrate (7), said plurality of one terminal pair surface acoustic wave elements (8-12) being connected so as to define a parallel arm resonator (10-12) and a series arm resonator (8-9) in a ladder circuit; and
a package (2) accommodating said surface acoustic wave filter element (3);
said surface acoustic wave filter element (3) being bonded via a plurality of bumps (28-31; 55a-57d; 75a-78b) by means of the face down process and being accommodated in said package (2); and
an inductance component (L1-L10) provided in said package (2) and connected to said parallel arm resonator (10-12);
wherein said package (2) includes a die-attach portion including a plurality of electrode pads (23-27; 55-57; 75-78) which are connected via said bumps (28-31; 55a-57d; 75a-78b) to one of a signal terminal (13, 17) and a ground terminal (14, 15, 16) of the surface acoustic wave filter element (3), and a plurality of external electrodes (41-44; 61-64; 81-84; 98a-98d) which are electrically connected to at least one of said electrode pads (23-27; 55-57; 75-78) and connected to one of a signal line and a ground line outside the surface acoustic wave filter device;
**characterized in that**
said inductance component (L1-L10) is obtained by a microstrip line (47-49; 67, 68; 87, 88; 97b, 97c),
wherein said microstrip line (47-49; 67, 68; 87, 88; 97b, 97c) is provided between said electrode pad (24-26; 57; 77; 78) which is connected to the ground terminal of at least one parallel arm resonator (10-12) via said bump and said external electrode (42, 43; 62, 63; 82, 83; 98b, 98c) which is connected to the ground line outside the package (2),
wherein said microstrip line (47-49; 67, 68; 87, 88; 97b, 97c) is disposed in the package (2) at a position other than the position of said die-attach portion, and
wherein the signal terminal (13, 17) at the input/output end of said surface acoustic wave filter element (3) and at least one ground terminal (14-16) thereof are arranged so as to be rotated by 90° about the imaginary line which passes the center of the piezoelectric substrate (7) of said surface acoustic wave filter element (3), and which is perpendicular to the piezoelectric substrate (7) with respect to the external electrode connected to the signal line at the input/output end and the external electrode connected to at least one ground potential among said plurality of external electrodes.

2. A surface acoustic wave filter device in accordance with claim 1, comprising:
a ground electrode (50) inside a base board (4) of the package (2); and
a belt-shaped conductive pattern provided on the base board (4) opposite the ground electrode (50) forming said microstrip line (47-49; 67, 68; 87, 88; 97b, 97c).

3. A surface acoustic wave filter device in accordance with claim 1 or 2, comprising a further microstrip line (45-46; 65-66; 85-86, 97a, 97d) connected between said electrode pad connected to the signal terminal of said series arm resonator (8-9) and said external electrode connected to the signal line outside said surface acoustic wave filter device.

4. A surface acoustic wave filter device in accordance with claim 1 or 2, comprising at least two said parallel arm resonators,
wherein the ground terminals of all said parallel arm resonators are commonly connected on said piezoelectric substrate ; and
said microstrip line is connected between the portion where the ground terminals of said parallel arm resonators are commonly connected and the external electrode provided in said package.

5. A surface acoustic wave filter device in accordance with claim 1 or 2, comprising at least two said parallel arm resonators (10-12),
wherein said package-side electrode pads connected to the ground terminals of all said parallel arm resonators (10-12) are made a common electrode pad (57); and
said microstrip line (67, 68) is provided on the path between said common electrode pad (57) and said external electrode (62, 63).

6. A surface acoustic wave filter device in accordance with claim 1 or 2, comprising:
at least three said parallel arm resonators (10-12); and
wherein an electrode pad (78) is provided to which the ground terminals of at least two parallel arm resonators (11-12) are connected,
wherein said microstrip line (88) is provided on the path between said electrode pad (78) connected to the ground terminals of at least two parallel arm resonators (11-12) and said external electrode (83) to which said electrode pad (78) is connected; and
wherein the parallel arm resonator (10) other than said at least two parallel arm resonators (11-12) is electrically isolated from said at least two parallel arm resonators (11-12) on the piezoelectric substrate (7), and is electrically connected to an external electrode (82) other than the external electrode (83) connected to said at least two parallel arm resonators (11-12).

7. A surface acoustic wave filter device in accordance with claim 1 or 2, comprising at least three said parallel arm resonators (10-12),
wherein said plurality of electrode pads include a common electrode pad (78) connected to the ground terminals of at least two parallel arm resonators (11-12) among said parallel arm resonators (10-12),
wherein said microstrip line (88) is provided on the path between the common electrode pad (78) and the external electrode (83) to which said common electrode pad (78) is connected; and
wherein the parallel arm resonator (10) other than said at least two parallel arm resonators (11-12) is electrically isolated from said at least two parallel arm resonators (11-12) on said die-attach portion including said plurality of electrode pads, and is electrically connected to an external electrode (82) other than the external electrode (83) connected to said at least two parallel arm resonators (11-12).

8. A surface acoustic wave filter device in accordance with any one of claims 1 to 7, wherein said package (2) includes a base board (4) on which said surface acoustic wave filter element (3) is mounted; an annular side wall (5) provided on said base board; (4) and a cap member (6) attached to said annual side wall so as to close the upper end thereof,
wherein at least 50% of the length of said microstrip line is disposed between said side wall (5) and said base board (4).

9. A surface acoustic wave filter device in accordance with any one of claims 1 to 7, wherein said package (2) includes a first case member (4) on which said surface acoustic wave filter element (3) is mounted,
wherein at least 50% of the length of said microstrip line is provided inside said first case member (4).

10. A communication device comprising a surface acoustic wave filter device in accordance with any one of claims 1 to 9.

## Patentansprüche

1. Ein Oberflächenwellenfilterbauelement, das folgende Merkmale aufweist:
ein Oberflächenwellenfilterelement (3), das ein piezoelektrisches Substrat (7) und
eine Mehrzahl von Ein-Anschluss-Paar-Oberflächenwellenelementen (8-12), die auf dem piezoelektrischen Substrat (7) vorgesehen sind, umfasst, wobei die Mehrzahl von Ein-Anschluss-Paar-Oberflächenwellenelementen (8-12) so verbunden ist, um einen Parallelarmresonator (10-12) und einen Serienarmresonator (8-9) in einer Leiterschaltung zu definieren, und
ein Gehäuse (2), das das Oberflächenwellenfilterelement (3) unterbringt;
wobei das Oberflächenwellenfilterelement (3) über eine Mehrzahl von Höckern (28-31; 55a-57d; 75a-78b) mittels des Vorderseite-Nach-Unten-Verfahrens gebondet ist und in dem Gehäuse (2) untergebracht ist; und
eine Induktivitätskomponente (L1-L10), die in dem Gehäuse (2) vorgesehen ist und mit dem Parallelarmresonator (10-12) verbunden ist;
wobei das Gehäuse (2) einen Chipanbringungsabschnitt umfasst, der eine Mehrzahl von Elektrodenanschlussflächen (23-27; 55-57; 75-78) umfasst, die über die Höcker (28-31; 55a-57d; 75a-78b) mit entweder einem Signalanschluss (13, 17) oder einem Masseanschluss (14, 15, 16) des Oberflächenwellenfilterelements (3) verbunden sind, sowie eine Mehrzahl externer Elektroden (41-44; 61-64: 81-84; 98a-98d), die elektrisch mit zumindest einer der Elektrodenanschlussflächen (23-27; 55-57; 75-78) verbunden sind und mit entweder einer Signalleitung oder einer Masseleitung außerhalb des Oberflächenwellenfilterbauelements verbunden sind;
**dadurch gekennzeichnet, dass**
die Induktivitätskomponente (L1-L10) durch eine Mikrostreifenleitung (47-49; 67, 68; 87, 88; 97b, 97c) erhalten wird,
wobei die Mikrostreifenleitung (47-49; 67, 68; 87, 88; 97b, 97c) zwischen der Elektrodenanschlussfläche (24-26; 57; 77; 78), die über den Höcker mit dem Masseanschluss zumindest eines Parallelarmresonators (10-12) verbunden ist, und der externen Elektrode (42, 43; 62, 63; 82, 83; 98b, 98c), die mit der Masseleitung außerhalb des Gehäuses (2) verbunden ist, vorgesehen ist,
wobei die Mikrostreifenleitung (47-49; 67, 68; 87, 88; 97b, 97c) in dem Gehäuse (2) an einer anderen Position als der Position des Chipanbringungsabschnitts angeordnet ist, und
wobei der Signalanschluss (13, 17) an dem Eingangs-/Ausgangsende des Oberflächenwellenfilterelements (3) und zumindest ein Masseanschluss (14-16) desselben so angeordnet sind, dass sie um 90° um die imaginäre Linie gedreht sind, die die Mitte des piezoelektrischen Substrats (7) des Oberflächenwellenfilterelements (3) durchläuft, und die senkrecht zu dem piezoelektrischen Substrat (7) in Bezug auf die externe Elektrode, die mit der Signalleitung an dem Eingangs-/Ausgangsende verbunden ist, und die externe Elektrode, die mit zumindest einem Massepotenzial verbunden ist, unter der Mehrzahl externer Elektroden ist.

2. Ein Oberflächenwellenfilterbauelement gemäß Anspruch 1, das folgende Merkmale aufweist:
eine Masseelektrode (50) im Inneren einer Grundplatte (4) des Gehäuses (2); und
eine bandförmige leitfähige Struktur, die auf der Grundplatte (4) vorgesehen ist, gegenüber von der Masseelektrode (50), die die Mikrostreifenleitung (47-49; 67, 68; 87, 88; 97b, 97c) bildet.

3. Ein Oberflächenwellenfilterbauelement gemäß Anspruch 1 oder 2, das eine weitere Mikrostreifenleitung (45-46; 65-66; 85-86; 97a, 97d) aufweist, die zwischen die Elektrodenanschlussfläche, die mit dem Signalanschluss des Serienarmresonators (8-9) verbunden ist, und die externe Elektrode, die mit der Signalleitung außerhalb des Oberflächenwellenfilterbauelements verbunden ist, geschaltet ist.

4. Ein Oberflächenwellenfilterbauelement gemäß Anspruch 1 oder 2, das zumindest zwei Parallelarmresonatoren aufweist,
wobei die Masseanschlüsse aller Parallelarmresonatoren zusammen auf dem piezoelektrischen Substrat verbunden sind; und
die Mikrostreifenleitung zwischen den Abschnitt, an dem die Masseanschlüsse der Parallelarmresonatoren zusammen verbunden sind, und die externe Elektrode, die in dem Gehäuse vorgesehen ist, geschaltet ist.

5. Ein Oberflächenwellenfilterbauelement gemäß Anspruch 1 oder 2, das zumindest zwei Parallelarmresonatoren (10-12) aufweist,
wobei die gehäuseseitigen Elektrodenanschlussflächen, die mit den Masseanschlüssen aller Parallelarmresonatoren (10-12) verbunden sind, zu einer gemeinsamen Elektrodenanschlussfläche (57) gemacht sind; und
die Mikrostreifenleitung (67, 68) auf dem Weg zwischen der gemeinsamen Elektrodenanschlussfläche (57) und der externen Elektrode (62, 63) vorgesehen ist.

6. Ein Oberflächenwellenfilterbauelement gemäß Anspruch 1 oder 2, das folgende Merkmale aufweist:
zumindest drei Parallelarmresonatoren (10-12); und
wobei eine Elektrodenanschlussfläche (78) vorgesehen ist, mit der die Masseanschlüsse zumindest zweier Parallelarmresonatoren (11-12) verbunden sind,
wobei die Mikrostreifenleitung (88) auf dem Weg zwischen der Elektrodenanschlussfläche (78), die mit den Masseanschlüssen zumindest zweier Parallelarmresonatoren (11-12) verbunden ist, und der externen Elektrode (83), mit der die Elektrodenanschlussfläche (78) verbunden ist, vorgesehen ist; und
wobei der Parallelarmresonator (10), der sich von den zumindest zwei Parallelarmresonatoren (11-12) unterscheidet, elektrisch von den zumindest zwei Parallelarmresonatoren (11-12) auf dem piezoelektrischen Substrat (7) getrennt ist und elektrisch mit einer anderen externen Elektrode (82) als der externen Elektrode (83) verbunden ist, die mit den zumindest zwei Parallelarmresonatoren (11-12) verbunden ist.

7. Ein Oberflächenwellenfilterbauelement gemäß Anspruch 1 oder 2, das zumindest drei Parallelarmresonatoren (10-12) aufweist,
wobei die Mehrzahl von Elektrodenanschlussflächen eine gemeinsame Elektrodenanschlussfläche (78) umfasst, die mit den Masseanschlüssen zumindest zweier Parallelarmresonatoren (11-12) unter den Parallelarmresonatoren (10-12) verbunden ist,
wobei die Mikrostreifenleitung (88) auf dem Weg zwischen der gemeinsamen Elektrodenanschlussfläche (78) und der externen Elektrode (83), mit der die gemeinsame Elektrodenanschlussfläche (78) verbunden ist, vorgesehen ist; und
wobei der Parallelarmresonator (10), der sich von den zumindest zwei Parallelarmresonatoren (11-12) unterscheidet, elektrisch von den zumindest zwei Parallelarmresonatoren (11-12) auf dem Chipanbringungsabschnitt, der die Mehrzahl von Elektrodenanschlussflächen umfasst, getrennt ist und elektrisch mit einer anderen externen Elektrode (82) als der externen Elektrode (83) verbunden ist, die mit den zumindest zwei Parallelarmresonatoren (11-12) verbunden ist.

8. Ein Oberflächenwellenfilterbauelement gemäß einem der Ansprüche 1 bis 7, bei dem das Gehäuse (2) eine Grundplatte (4), auf der das Oberflächenwellenfilterelement (3) befestigt ist; eine ringförmige Seitenwand (5), die auf der Grundplatte (4) vorgesehen ist; und ein Deckelbauteil (6), das an der ringförmigen Seitenwand angebracht ist, um so das obere Ende desselben abzuschließen, umfasst,
wobei zumindest 50% der Länge der Mikrostreifenleitung zwischen der Seitenwand (5) und der Grundplatte (4) angeordnet sind.

9. Ein Oberflächenwellenfilterbauelement gemäß einem der Ansprüche 1 bis 7, bei dem das Gehäuse (2) ein erstes Behälterbauteil (4) umfasst, an dem das Oberflächenwellenfilterelement (3) befestigt ist,
wobei zumindest 50% der Länge der Mikrostreifenleitung im Inneren des ersten Behälterbauteils (4) vorgesehen sind.

10. Eine Kommunikationsvorrichtung, die ein Oberflächenwellenfilterbauelement gemäß einem der Ansprüche 1 bis 9 aufweist.

## Revendications

1. Dispositif de filtre à ondes acoustiques de surface, comprenant :
un élément de filtre à ondes acoustiques de surface (3) comprenant un substrat piézoélectrique (7) et une pluralité d'éléments d'onde acoustique de surface d'une paire de bornes (8 à 12) prévus sur ledit substrat piézoélectrique (7), ladite pluralité d'éléments d'onde acoustique de surface d'une paire de bornes (8 à 12) étant connectés de manière à définir un résonateur à branches en parallèle (10 à 12) et un résonateur à branches en série (8 à 9) en un circuit en échelle ; et
un boîtier (2) contenant ledit élément de filtre à ondes acoustiques de surface (3) ;
ledit élément de filtre à ondes acoustiques de surface (3) étant lié par l'intermédiaire d'une pluralité de bossages (28 à 31 ; 55a à 57d ; 75a à 78b) au moyen du processus de retournement de face et étant logé dans ledit boîtier (2) ; et
une composante d'inductance (L1 à L10) prévue dans ledit boîtier (2) et connectée audit résonateur à branches en parallèle (10 à 12) ;
dans lequel ledit boîtier (2) comprend une partie de fixation de puce comprenant une pluralité de pastilles d'électrode (23 à 27 ; 55 à 57 ; 75 à 78) qui sont connectées par l'intermédiaire desdits bossages (28 à 31 ; 55a à 57d ; 75a à 78b) à l'une d'une borne de signal (13, 17) et d'une borne de masse (14, 15, 16) de l'élément de filtre à ondes acoustiques de surface (3), et une pluralité d'électrodes externes (41 à 44 ; 61 à 64 ; 81 à 84 ; 98a à 98d) qui sont connectées électriquement à au moins l'une desdites pastilles d'électrode (23 à 27 ; 55 à 57 ; 75 à 78) et connectées à l'une d'une ligne de signal et d'une ligne de masse à l'extérieur du dispositif de filtre à ondes acoustiques de surface ;
**caractérisé en ce que**
ladite composante d'inductance (L1 à L10) est obtenue par une ligne à microruban (47 à 49 ; 67, 68 ; 87, 88 ; 97b, 97c),
dans lequel ladite ligne à microruban (47 à 49 ; 67, 68 ; 87, 88 ; 97b, 97c) est prévue entre ladite pastille d'électrode (24 à 26 ; 57 ; 77 ; 78) qui est connectée à la borne de masse d'au moins un résonateur à branches en parallèle (10 à 12) par l'intermédiaire dudit bossage et ladite électrode externe (42, 43 ; 62, 63 ; 82, 83 ; 98b, 98c) qui est connectée à la ligne de masse à l'extérieur du boîtier (2),
dans lequel ladite ligne à microruban (47 à 49 ; 67, 68 ; 87, 88 ; 97b, 97c) est disposée dans le boîtier (2) à une position autre que la position de ladite partie de fixation de puce, et
dans lequel la borne de signal (13, 17) à l'extrémité d'entrée/sortie dudit élément de filtre à ondes acoustiques de surface (3) et au moins une borne de masse (14 à 16) de celui-ci sont agencées de manière à être tournées de 90° autour de la ligne imaginaire qui passe par le centre du substrat piézoélectrique (7) dudit élément de filtre à ondes acoustiques de surface (3), et qui est perpendiculaire au substrat piézoélectrique (7) par rapport à l'électrode externe connectée à la ligne de signal à l'extrémité d'entrée/sortie et à l'électrode externe connectée à au moins un potentiel de masse parmi ladite pluralité d'électrodes externes.

2. Dispositif de filtre à ondes acoustiques de surface selon la revendication 1, comprenant :
une électrode de masse (50) à l'intérieur d'une plaque de base (4) du boîtier (2) ; et
un motif conducteur en forme de bande prévu sur la plaque de base (4) face à l'électrode de masse (50) formant ladite ligne à microruban (47 à 49 ; 67, 68 ; 87, 88 ; 97b, 97c).

3. Dispositif de filtre à ondes acoustiques de surface selon la revendication 1 ou 2, comprenant une autre ligne à microruban (45 et 46 ; 65 et 66 ; 85 et 86, 97a, 97d) connectée entre ladite pastille d'électrode connectée à la borne de signal dudit résonateur à branches en série (8 et 9) et ladite électrode externe connectée à la ligne de signal à l'extérieur dudit dispositif de filtre à ondes acoustiques de surface.

4. Dispositif de filtre à ondes acoustiques de surface selon la revendication 1 ou 2, comprenant au moins deux dits résonateurs à branches en parallèle,
dans lequel les bornes de masse de tous lesdits résonateurs à branches en parallèle sont généralement connectées sur ledit substrat piézoélectrique ; et
ladite ligne à microruban est connectée entre la partie dans laquelle les bornes de masse desdits résonateurs à branches en parallèle sont généralement connectées et l'électrode externe prévue dans ledit boîtier

5. Dispositif de filtre à ondes acoustiques de surface selon la revendication 1 ou 2, comprenant au moins deux dits résonateurs à branches en parallèle (10 à 12),
dans lequel lesdites pastilles d'électrode côté boîtier connectées aux bornes de masse de tous lesdits résonateurs à branches en parallèle (10 à 12) réalisent une pastille d'électrode commune (57) ; et
ladite ligne à microruban (67, 68) est prévue sur le trajet entre ladite pastille d'électrode commune (57) et ladite électrode externe (62, 63).

6. Dispositif de filtre à ondes acoustiques de surface selon la revendication 1 ou 2, comprenant :
au moins trois dits résonateurs à branches en parallèle (10 à 12) ; et
dans lequel une pastille d'électrode (78) est prévue à laquelle les bornes de masse d'au moins deux résonateurs à branches en parallèle (11 et 12) sont connectées,
dans lequel ladite ligne à microruban (88) est prévue sur le trajet entre ladite pastille d'éléctrode (78) connectée aux bornes de masse d'au moins deux résonateurs à branches en parallèle (11 et 12) et ladite électrode externe (83) à laquelle ladite pastille d'électrode (78) est connectée ; et
dans lequel le résonateur à branches en parallèle (10) autre que lesdits au moins deux résonateurs à branches en parallèle (11 et 12) est isolé électriquement desdits au moins deux résonateurs à branches en parallèle (11 et 12) sur le substrat piézoélectrique (7), et est connecté électriquement à une électrode externe (82) autre que l'électrode externe (83) connectée auxdits au moins deux résonateurs à branches en parallèle (11 et 12).

7. Dispositif de filtre à ondes acoustiques de surface selon la revendication 1 ou 2, comprenant au moins trois dits résonateurs à branches en parallèle (10 à 12),
dans lequel ladite pluralité de pastilles d'électrode comprennent une pastille d'électrode commune (78) connectée aux bornes de masse d'au moins deux résonateurs à branches en parallèle (11 et 12) parmi lesdits résonateurs à branches en parallèle (10 à 12),
dans lequel ladite ligne à microruban (88) est prévue sur le trajet entre la pastille d'électrode commune (78) et l'électrode externe (83) à laquelle ladite pastille d'électrode commune (78) est connectée ; et
dans lequel le résonateur à branches en parallèle (10) autre que lesdits au moins deux résonateurs à branches en parallèle (11 et 12) est isolé électriquement desdits au moins deux résonateurs à branches en parallèle (11 et 12) sur ladite partie de fixation de puce comprenant ladite pluralité de pastilles d'électrode, et est connecté électriquement à une électrode externe (82) autre que l'électrode externe (83) connectée auxdits au moins deux résonateurs à branches en parallèle (11 et 12).

8. Dispositif de filtre à ondes acoustiques de surface selon l'une quelconque des revendications 1 à 7, dans lequel ledit boîtier (2) comprend une plaque de base (4) sur laquelle ledit élément de filtre à ondes acoustiques de surface (3) est monté ; une paroi latérale annulaire (5) prévue sur ladite plaque de base (4) ; et un élément de recouvrement (6) attaché à ladite paroi latérale annulaire de manière à fermer l'extrémité supérieure de celle-ci,
dans lequel au moins 50 % de la longueur de ladite ligne à microruban est disposée entre ladite paroi latérale (5) et ladite plaque de base (4).

9. Dispositif de filtre à ondes acoustiques de surface selon l'une quelconque des revendications 1 à 7, dans lequel ledit boîtier (2) comprend un premier élément de carter (4) sur lequel ledit élément de filtre à ondes acoustiques de surface (3) est monté,
dans lequel au moins 50 % de la longueur de ladite ligne à microruban est prévue à l'intérieur dudit premier élément de carter (4).

10. Dispositif de communication comprenant un dispositif de filtre à ondes acoustiques de surface selon l'une quelconque des revendications 1 à 9.
